# EUROPEAN PATENT SPECIFICATION

(11) **EP 2 514 857 B1**
(45) Date of publication and mention of the grant of the patent: **21.02.2018**
(21) Application number: 10837482.8
(22) Date of filing: 08.12.2010
(51) Int. Cl.: C30B 25/18, C30B 25/16, C30B 25/02, C30B 29/36, H01L 21/02, H01L 29/16, H01L 29/04

(54) **SiC EPITAXIAL WAFER AND METHOD FOR MANUFACTURING SAME**
EPITAKTISCHER SILICIUMCARBIDWAFER UND HERSTELLUNGSVERFAHREN DAFÜR
GALETTE ÉPITAXIALE SiC ET SON PROCÉDÉ DE FABRICATION

(30) Priority: 14.12.2009 JP 2009283113
(43) Date of publication of application: 24.10.2012
(73) Proprietor: Showa Denko K.K., Tokyo 105-8518 (JP)
(72) Inventor: MUTO Daisuke, Chichibu-shi Saitama 369-1893 (JP); MOMOSE Kenji, Chichibu-shi Saitama 369-1893 (JP); ODAWARA Michiya, Chichibu-shi Saitama 369-1893 (JP)
(74) Representative: Strehl Schübel-Hopf & Partner
(86) International application number: PCT/JP2010/071989
(87) International publication number: WO 2011/074453

(56) References cited:
- EP-A1- 1 752 567
- EP-A1- 1 895 573
- WO-A1-2009/035095
- WO-A1-2009/035095
- JP-A- 2006 321 707
- JP-A- 2007 182 330
- US-A1- 2009 302 326
- WADA K ET AL: "Epitaxial growth of 4H-SiC on 4<o> off-axis (0001) and (0001@?) substrates by hot-wall chemical vapor deposition", JOURNAL OF CRYSTAL GROWTH, ELSEVIER, AMSTERDAM, NL, vol. 291, no. 2, 1 June 2006 (2006-06-01), pages 370-374, XP028016535, ISSN: 0022-0248, DOI: 10.1016/J.JCRYSGRO.2006.03.039 [retrieved on 2006-06-01]

## Description

### TECHNICAL FIELD

The present invention relates to a method of manufacture of an SiC epitaxial wafer. Specifically, it relates to a method of manufacture of a high-quality SiC epitaxial wafer which has low defect density, which is highly uniform in film thickness and carrier concentration, and which is free of step bunching.

Priority is claimed on Japanese Patent Application No. 2009-283113, filed December 14,2009.

### BACKGROUND ART

In response to the problem of global warming, there is demand for enhancement of energy conservation technology. Among the many technological matters being treated, power electronics technology which reduces energy loss during power conversion is situated as a core technology. Power electronics has undergone technological improvement and performance enhancement using conventional silicon (Si) semiconductors, but it is said that performance enhancement is approaching its limits due to limits on the material and physical properties of silicon. Consequently, expectations have come to focus on silicon carbide (SiC), whose physical limits can be set higher than those of silicon. For example, compared to silicon, silicon carbide has superior physical properties such as bandwidth that is approximately 3 times larger, dielectric breakdown field intensity that is approximately 10 times larger, and thermal conductivity that is approximately 3 times larger, and its application to power devices, high-frequency devices, high-temperature operating devices and so on is much anticipated.

To promote the practical use of SiC devices, it is indispensable to establish high-quality crystal growth technology and high-quality epitaxial growth technology.

SiC has many polytypes, but the one that is primarily used to fabricate SiC devices for practical use is 4H-SiC. As substrates of SiC devices, SiC single crystal wafers are used which are processed from bulk crystal fabricated by the sublimation method or the like, on top of which SiC epitaxial film constituting the active region of the SiC device is ordinarily formed by chemical vapor deposition (CVD).

Polytypes that differ from the polytype used in the substrate tend to become incorporated into the epitaxial film. For example, 3C-SiC and 8H-SiC are incorporated when 4H-SiC is used in the substrate. Incorporation of different polytypes disturbs the laminar structure of the crystal lattice, causing stacking faults.

In order to inhibit such incorporation, epitaxial growth is ordinarily conducted by slightly tilting the SiC single crystal substrate, and conducting step-flow growth (lateral growth from an atomic step), but steps of high growth rate overtake and combine with steps of slow growth rate, causing step bunching.

To fabricate high-quality epitaxial film, it is necessary to reduce stacking faults and step bunching. It is also necessary to reduce triangular-shaped defects (hereinafter "triangular defects") in the surface of the epitaxial film, and reduce irregularities in in-plane film thickness and irregularities in carrier concentration.

### <Epitaxial growth on low off-angle SiC single crystal substrates>

When the size of the SiC substrate is up to 5.08 cm (2 inches), 8° is primarily used as the off angle of the SiC single crystal substrate. With this off angle, the terrace width of the wafer surface is small, and step-flow growth is easily obtained, but as the off angle increases, the number of wafers obtained from an SiC ingot decreases. Consequently, with respect to SiC substrates of 7.62 cm (3 inches) or more, substrates with an off angle on the order of 4° are primarily used.

From the standpoint of cost reduction, there is a need to establish epitaxial growth technology for SiC single crystal substrates with lower off angles, the optimal one being a slightly tilted off-angle of 0.4° which is known as an off angle enabling step-flow growth.

However, because the terrace width of the surface of the SiC single crystal substrate (wafer) increases as the off-angle decreases, irregularities tend to occur in the rate of introduction of the migrating atoms that are introduced at the step edges, i.e., the growth rate of the step edges. As a result, there is the problem that steps of high growth rate overtake and combine with steps of low growth rate, causing step bunching. Step bunching is particularly facilitated in the case where the epitaxial surface is an Si surface, because migration of surface atoms is inhibited more than in the case of a C surface. The reduction of step bunching is a major issue with respect to utilization of low off-angle SiC single crystal substrates.

For example, with a wafer of 0.4° off-angle, terrace width is 10 times larger than with a wafer of 4° off-angle, and the length of step-flow growth is one digit longer. Consequently, it is feared that the conventional step-flow growth conditions that have been used heretofore will not be applicable as is.

### <Step bunching and its observation/evaluation>

Step bunching is a phenomenon where atomic steps (ordinarily on the order of 2-10 atomic layers) aggregate and unite on a surface, and sometimes refers to the unevenness itself of this surface. Non-Patent Document 2 illustrates representative step bunching.

Heretofore, observation/evaluation of step bunching has frequently been conducted with a combination of an atomic force microscope (AFM) having atomic resolution and an optical microscope such as a differential interference microscope (e.g., Non-Patent Documents 2 and 3).

### <Triangular defects and stacking faults, and their observation/evaluation>

In this Description, "triangular defects" are defects of approximately triangular shape which have vertical sides in the [11-20] direction that minutely tilt the SiC single crystal substrate, and which exist on the surface of epitaxial film (in this Description, with respect to the notation of Miller's index, "-" signifies the bar that is attached to the immediately following index). The size thereof depends on the off-angle, depth at origin of the defect, and film thickness, but when observed from the surface side of the epitaxial film, the size of one side is on the order of 2 µm-1 mm, and height/depth is on the order of 50 nm. Detection is possible by means of an optical surface inspection device using laser light, a wide-view atomic force microscope, a differential interference microscope, or the like.

Stacking faults are a type of planar defect that arises due to dislocation of the stacking of crystal lattice planes. In this Description, "stacking faults" are detected by photoluminescence (PL) measurement as approximately triangular luminous spots or dark spaces which have vertical sides in the [11-20] direction that minutely tilt the SiC single crystal substrate. The size thereof depends on the off-angle, depth at origin of the defect, and film thickness, but when observed from the surface side of the epitaxial film, the size of one side is on the order of 2 µm to 400 µm, and area is on the order of 100 µm² to 80000 µm². In the case of luminescence, a stacking fault of the 3C polytype is detected in the vicinity of 420-430 nm, and a stacking fault of the 8H polytype is detected in the vicinity of 460 nm. In the case where detection is conducted with IR light of 750 nm or higher, all stacking faults including 3C and 8H are detected as darkened spaces (Non-Patent Document 1).

As stacking faults which exist in the epitaxial film can be detected by photoluminescence (PL) measurement, the "stacking faults" of the present Description include "stacking faults" which exist throughout the entirety of the epitaxial film. Accordingly, defects which exist in the epitaxial film but which do not appear on the surface are also included, which is a point of difference with "triangular defects" which concern only what appears on the surface of the epitaxial film.

With respect to methods for reducing "triangular defects," Patent Document 1 reports that: triangular defect density was 2.5 defects/cm² in the surface of a 5 µm SiC epitaxial layer ("defect reduction layer") which was grown on an SiC single crystal substrate at a growth temperature of 1625°C with an atom number ratio of carbon and silicon (C/Si ratio) contained in the raw material gas of 0.7 (Working Example 1); setting the layer thickness of this defect reduction layer to 0.5 µm, triangular defect density was 2 defects/cm² in the surface of a 10 µm SiC epitaxial layer (active layer) which was grown on this layer at the same growth temperature (1625°C) with an atom number ratio (C/Si ratio) of 1.2 (Working Example 2); and furthermore, without forming a defect reduction layer, triangular defect density was 5-10 defects/cm² in the surface of a 10 µm SiC epitaxial layer which was grown at 1625°C with an atom number ratio (C/Si ratio) of 1.6 (Comparative Example).

In Patent Document 1, it is noteworthy that epitaxial growth is conducted at a growth temperature that is higher than the conventional growth temperature of 1500-1600°C, and formation of a "defect reduction layer" is considered necessary in order to reduce "triangular defects." Moreover, it is shown that triangular defect density cannot be reduced merely with the requirement of a growth temperature of "1625°C" that is higher than the conventional growth temperature.

### <Gas etching and raw material gas supply>

Conventionally, when SiC epitaxial film is grown on an SiC single crystal substrate, mechanical polishing is conducted, after which chemical mechanical polishing (CMP) and gas etching are performed in sequence, and surface treatment of the SiC single crystal substrate is conducted, followed by formation of the SiC epitaxial film by chemical vapor deposition. With respect to gas etching, etching is conducted primarily using hydrogen gas at a high temperature on the order of 1500°C as pretreatment, for purposes of surface planarization and removal of polishing marks (scratches) and damage stemming from the polishing process.

Gas etching has been conducted while adding propane (C₃H₈) gas, which is a raw material gas of SiC epitaxial film, to a hydrogen atmosphere (Patent Document 2; paragraph [0002] of Patent Document 3; and Non-Patent Document 4). As shown in Non-Patent Document 4, hydrogen gas etching is considered to be indispensable for obtainment of a satisfactory epitaxial surface, but it is shown that hydrogen alone generates Si droplets, and it is considered that addition of C₃H₈ is effective in inhibiting generation thereof.

However, when polishing marks (scratches) and damage from polishing also remain on the substrate surface after gas etching, there is the problem that different polytypes as well as dislocation, stacking faults and the like are introduced into the epitaxial film that is subsequently formed on the substrate surface. When gas etching time is prolonged and the etching amount is increased in order to avoid this, there is the problem that surface reconfiguration then occurs on the substrate surface, and that step bunching occurs on the substrate surface prior to initiation of epitaxial growth.

Thus, as a method of reducing the etching amount in order to inhibit occurrence of this step bunching, a method has been proposed wherein gas etching is conducted while adding silane (SiH₄) gas which is a raw material gas to the hydrogen gas (Patent Document 3).

With either of the methods of Patent Documents 2 and 3, gas etching is conducted by adding C₃H₈ gas or SiH₄ gas as the raw material gas of the SiC epitaxial film, and the SiC epitaxial film formation process is entered by proceeding as is to the introduction of another gas without evacuating the additive gas after gas etching (Patent Document 2, Fig. 2; Patent Document 3, Fig. 4). That is, prior to the start of growth of the SiC epitaxial film, a condition exists where propane (C₃H₈) gas or silane (SiH₄) gas already exists in the surface of the SiC substrate.

Thus, with the methods now commonly being conducted as represented by Patent Documents 2 and 3, the C₃H₈ gas and SiH₄ gas which are raw material gases are not simultaneously supplied at the time when growth of the SiC epitaxial film is started.

EP 1 895 573 A1 and EP 1 752 567 A1 disclose an SiC epitaxial wafer in which an SiC epitaxial layer is formed on a 4H-SiC single crystal substrate tilted with an off angle of less than 2° or less than 0.4-2°, respectively. EP 1 895 573 A1 is considered to disclose a method of manufacturing an SiC epitaxial wafer according to the preamble of independent claim 1.

### PRIOR ART REFERENCES

### PATENT DOCUMENTS

Patent Document 1: Japanese Unexamined Patent Application, First Publication No. 2009-256138
Patent Document 2: Patent Publication No. 4238357
Patent Document 3: Japanese Unexamined Patent Application, First Publication No. 2005-277229

### NON-PATENT DOCUMENTS

Non-Patent Document 1: Materials Science Forum vols. 615-617(2009) pp. 129-132
Non-Patent Document 2: Mater. Sci. Forum 527-529, (2006) pp. 239-242
Non-Patent Document 3: Journal Cryst. Growth 291, (2006) pp. 370-374
Non-Patent Document 4: Journal Cryst. Growth 237-239, (2002) pp. 1213-1218

### DISCLOSURE OF INVENTION

### PROBLEMS THAT THE INVENTION IS TO SOLVE

The present invention was made in light of the foregoing circumstances, and its object is to offer a method of manufacturing an SiC epitaxial wafer which is of particularly high-quality compared to conventional wafers, which reduces triangular defects and stacking faults, which improves uniformity of film thickness and carrier concentration, and which is free of step bunching so that there is no step bunching anywhere on the surface of the wafer.

### MEANS FOR SOLVING THE PROBLEMS

As triangular defects and stacking faults adversely affect SiC device properties, yield, and reliability, their reduction is indispensable. With respect to low off angle SiC epitaxial wafers, a method for reducing triangular defects is disclosed in Patent Document 1, but there are currently scarcely any reports concerning a method for reducing stacking faults.

With respect to reduction of triangular defects and stacking faults, first, the relation between growth temperature during epitaxial growth and the density of triangular defects and stacking faults was investigated.

**Table 1**

| Growth temperature (°C) | Triangular defect density (cm⁻²) | Stacking fault density (cm⁻²) |
|---|---|---|
| 1500 | 14.6 | 81.9 |
| 1550 | 3 | 6.9 |
| 1600 | 2.4 | 2.8 |
| 1650 | 0.6 | 0 |

Table 1 shows the results of triangular defect densities and stacking fault densities of SiC epitaxial wafers for which an SiC epitaxial layer was formed at a growth temperature of 1500°C-1650°C at a fixed growth rate of 5 µm/h on the Si surface of a 4H-SiC single crystal substrate tilted at an off angle of 4°. In contrast to 1500°C-1600°C, which is the temperature range ordinarily used for conventional growth temperature, 1650°C is 50°C higher than the temperature range of ordinary use.

The results for triangular defect density were obtained by conducting measurement by an optical surface inspection device using laser light (Candela CS20 manufactured by KLA-Tencor Corporation), and the results for stacking fault density were obtained by conducting measurement by a photoluminescence imaging device (PLI-100 manufactured by Photon Design Corporation).

Triangular defects and stacking faults share the same primary causes: (1) downfall and the like of foreign matter inside the film formation apparatus; and (2) step flow insufficiencies during growth. It would seem that (1) downfall and the like of foreign matter inside the film formation apparatus plays the major role with respect to triangular defects, and that (2) step flow insufficiencies during growth play the major role with respect to stacking faults.

At a growth temperature of 1500°C-1600°C, stacking fault density is greater than triangular defect density. This indicates that, in the temperature range ordinarily used for conventional growth temperature, the role of (2) step flow insufficiencies during growth is greater than the role of (1) downfall and the like of foreign matter inside the film formation apparatus.

In contrast, at a growth temperature 1650°C, triangular defect density is greater than stacking fault density. This indicates that, at 1650°C which is higher than the temperature range ordinarily used for conventional growth temperature, the role of (1) downfall and the like of foreign matter inside the film formation apparatus is greater than the role of (2) step flow insufficiencies during growth.

These results indicate that, at temperatures higher than conventional growth temperatures (1400-1600°C), temperatures exist at which more satisfactory step flow growth is conducted. That is, it would seem that growth which is closer to theory is conducted at temperatures which are higher than conventional growth temperatures (1400-1600°C).

As a result of diligent research, the present inventors discovered a suitable combination of growth temperature and growth rate which markedly reduces triangular defects and stacking faults by reviewing growth temperature and growth rate at each off angle in a range of 0.4-5°.

Furthermore, with respect to reduction of triangular defects and stacking faults, they noticed differences in heating conditions on the front surface (the epitaxial film formation surface, which is the primary surface) and rear surface of the SiC single crystal substrate during epitaxial growth. That is, the SiC single crystal substrate is heated during epitaxial growth, and the rear surface of the SiC single crystal substrate is supported by direct contact with a support member that supports the SiC single crystal substrate, and is directly heated from the support member. In contrast, the front surface is in a state of exposure to vacuum space for purposes of epitaxial film formation, and is not directly heated. Furthermore, as hydrogen which is a carrier gas flows over the front surface, heat is carried off. As a result of these factors, the temperature of the front surface is lower than that of the rear surface during epitaxial growth. For example, in the case of a film formation apparatus of the hot-wall type, the front surface is heated by radiant heat from a radiation heating member disposed at a distance from the wafer and by conductive heat transmitted through the interior of the substrate from the rear surface. Due to such differences in heating conditions between the front surface (primary surface) and rear surface of the SiC single crystal substrate during epitaxial growth, the front surface is in a lower temperature state than the rear surface. Owing to this temperature difference, the extent of thermal expansion is smaller in the front surface than in the rear surface, and the front surface of the SiC single crystal substrate deforms into a concavity during epitaxial growth. The amount of this deformation increases as the temperature difference between the front surface and the rear surface of the wafer increases. Consequently, when the wafer is heated at a temperature that is higher than in the past as in the present invention, the amount of deformation becomes larger than in the past, and thereby constitutes a more pronounced problem. In particular, the peripheral region of the wafer rises up from the heating member that supports the wafer, and the temperature of the wafer surface falls below the required temperature.

As a result, even in the case where epitaxial growth is conducted in a temperature range and growth rate range where triangular defects and stacking faults do not occur, triangular defects and stacking faults occur in high density in the peripheral portion. Furthermore, it was noted that warpage of the SiC single crystal substrate is microscopically warpage of the crystal lattice surface, and that deposition of an epitaxial layer in a state where the crystal lattice surface of the substrate surface has been rendered concave is linked to formation of defects such as dislocation, which could be a cause of stacking faults.

It was then conceived of how epitaxial growth could be conducted in a state where the concavity (warp) of the substrate stemming from differences in heating conditions of the front surface (primary surface) and rear surface of the SiC single crystal substrate during epitaxial growth was eliminated. Specifically, an SiC single crystal substrate was fabricated so as to become convex with respect to the primary surface at room temperature, and epitaxial growth was conducted in a state where the concavity (warp) of the substrate was reduced, and preferably eliminated, during epitaxial growth.

As a result, by producing a state where the concavity (warp) of the substrate is reduced and preferably eliminated, it was found that the substrate support member and the SiC single crystal substrate come into close contact, and that the uniformity of substrate temperature distribution (particularly the large temperature difference between the central portion and the peripheral portion) is improved, with the result that uniformity of film thickness and carrier concentration is enhanced.

The current situation with respect to a method for reducing step bunching is as follows.

Although an AFM having atomic resolution (hereinafter "normal AFM") is capable of direct observation of the atomic arrangement of the surface, its maximum observation range is on the order of 10-20 µm square, and wide-range observation beyond that is mechanically difficult. However, as the step bunching of an SiC epitaxial film surface is perceived continuously from end to end of the wafer, the AFM has been used in combination with an optical microscope, with the result that no particular disadvantages have arisen from the mechanical drawbacks of the AFM.

In addition, a differential interference microscope could be used for observation over a range of 200 µm to 1 mm square which is a wider range than that of the AFM, but with this differential interference microscope (e.g., Non-Patent Document 3), there are the disadvantages that step height cannot be quantified, and that - particularly when magnification is high - steps with a height of several nm cannot be detected.

As step bunching hinders planarization of the SiC epitaxial film surface, it is necessary to suppress occurrence thereof in order to obtain higher performance SiC devices. As step bunching is surface unevenness, its existence may have fatal effects on operational performance and reliability, particularly with respect to MOSFETs (metal-oxide-semiconductor field-effect transistors) which form oxide film on the SiC epitaxial film surface and which apply current to the interface thereof. Consequently, research on the inhibition of such step bunching has heretofore been vigorously conducted.

The active region of an SiC power device including this MOSFET is larger than the measurement range of a normal AFM. Consequently, for purposes of obtaining an epitaxial growth surface enabling fabrication of devices with excellent properties, evaluation by a normal AFM or differential interference microscope has been insufficient.

As stated above, it has been common to conduct gas etching by adding C₃H₈ or SiH₄ gas which is raw material gas, and to subsequently conduct the SiC epitaxial film formation process by proceeding as is to the introduction of another gas without evacuating the additive gas. In this case, these raw material gases are not simultaneously supplied to the substrate surface. Although in some cases etching was conducted only with hydrogen gas, the importance of simultaneous supply of raw material gases to the substrate surface was not recognized.

### <Short step bunching>

Using in combination an AFM of the wide-range observation type (hereinafter "wide-range observation type AFM") and an optical surface inspection device which has a height sensitivity of the same order as an AFM, which uses laser light, and which is capable of observation over a wider range than a differential interference microscope, the present inventors conducted observation/evaluation of an SiC epitaxial wafer regarding which step bunching was deemed to have been inhibited by the conventional method, and found that step bunching which is difficult to grasp with a normal AFM or differential interference microscope exists in a standard surface condition.

The step bunching whose existence was newly revealed occurs at average intervals of 100 µm, and has a length of 100-500 µm in the [1-100] direction. As described below, with respect to the cause of occurrence of this step bunching, shallow pits that are formed by the emergence of spiral dislocations in the growth surface form irregularities in the surface. As the spiral dislocations are originally contained in the SiC single crystal substrate used as the substrate of the epitaxial growth film, this step bunching may be said to derive from the substrate.

On the other hand, the conventionally known step bunching (hereinafter "conventional step bunching") exists at average intervals of 1.5 µm, and has a length of 5 mm in the [1-100] direction. With respect to its occurrence, as there are off angles in the surface of an SiC single crystal substrate, atomic steps corresponding thereto exist in the surface, and these atomic steps are moved by the epitaxial growth or gas etching process, triggering a mutual uniting of steps when irregularities arise among these steps in the rate of this movement. Thus, it occurs without relation to dislocations in the substrate.

In the present Description, in order to distinguish the step bunching whose existence has been newly discovered from conventional step bunching, the former is described as "short step bunching."

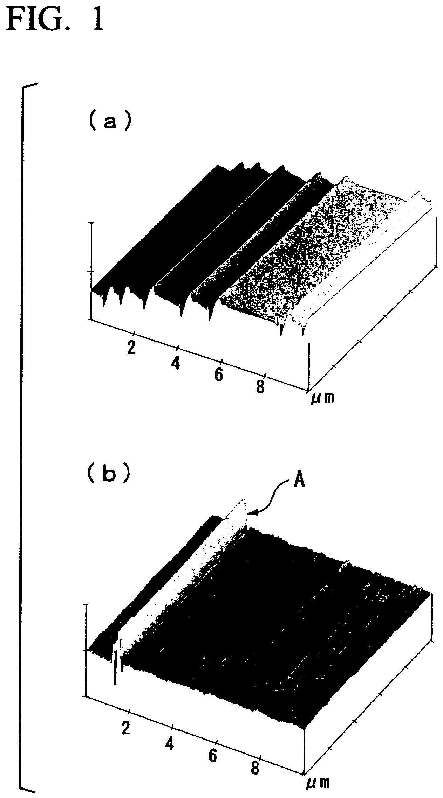

Fig. 1 shows an AFM image (a surface perspective image of a stereoscopic display) of 10 µm square of an SiC epitaxial wafer surface observed by a normal AFM (Dimension V manufactured by Veeco Instrument Corporation). Fig. 1(a) is an AFM image that shows conventional step bunching, and Fig. 1(b) is an AFM image that shows short step bunching.

In the case where an AFM image like the one shown by arrow mark A in Fig. 1(b) would be obtained, or in the case where a portion of such an AFM image would be obtained by multiple reciprocal scans of a cantilever rather than by scanning of a single screen, it would ordinarily be judged as noise, or it would be judged as observation of a region that randomly has a peculiar condition, rather than as showing a standard surface condition. Consequently, although one could say that short step bunching should have been observed previously even by normal AFMs or differential interference microscopes, it was, at the very least, not recognized as showing a standard condition of an SiC epitaxial film surface.

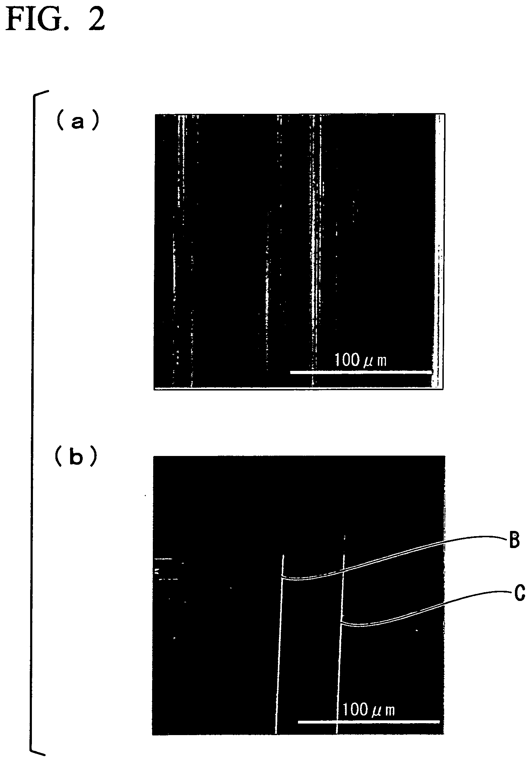

Fig. 2 shows an AFM image of 200 µm square of an SiC epitaxial film surface observed by the wide-range observation type AFM (Nanoscale Hybrid Microscope VN-8000 manufactured by Keyence Corporation) used in the present invention.

Fig. 2(a) is an AFM image that shows conventional step bunching, and Fig. 2(b) is an AFM image that shows short step bunching.

With respect to conventional step bunching, as shown in Fig. 2(a), it can be observed to exist at an average interval of 1.5 µm, as in a normal AFM image. In contrast, it is clear in Fig. 2 (b) that two lines (arrow marks B and C) are stably observed over an equal interval. The ability to stably observe steps in this manner over a wide range of 200 µm square does not merely show noise or a peculiar surface region, and corroborates the existence of step bunching of a different nature from conventional step bunching.

In order to confirm the existence of short step bunching with another surface inspection device, observation was conducted by an optical surface inspection device (Candela CS20 manufactured by KLA-Tencor Corporation) using laser light. As this optical surface inspection device has an observation range which covers the entire wafer surface from several µm square to 10.16 cm² (4 inches square) and which is larger than that of a wide-range observation type AFM, it is well-suited to measuring the density of short step bunching.

The optical surface inspection device used in the present invention (a device which conducts surface inspection by the same principles as the Candela CS20 manufactured by KLA-Tencor Corporation) is characterized by having a system in which laser light is obliquely incident on a wafer, and which detects the intensity of scattering light from the wafer surface, as well as the intensity of reflected light and the reflection position. The wafer surface is subjected to spiral scanning. As reflection position varies so as to trace the unevenness of the wafer surface, it is possible to compute roughness (surface roughness) from this position information. As surface roughness information is extracted in a frequency corresponding to step bunching, a 100 µm filter is used during calculation to remove long-period undulation information of the wafer surface.

However, as the step bunching is parallel in the [1-100] direction, the steps are not detected in regions where the laser light and the scanning direction are parallel during spiral scanning. Consequently, to compute roughness information, the 70° ranges of 55°-125° and 235°-305° are respectively selected in general polar coordinates. Moreover, as the center of spiral scanning constitutes a singularity where laser light does not move, the position information for reflected light in its vicinity no longer mirrors roughness. Consequently, the range of ϕ10 mm at the center is removed from the computation region. The range of calculation which is set in this manner covers approximately 35% of the entire wafer surface, but the morphology of this range approximately mirrors the entire wafer surface in so far as step bunching is concerned. As the roughness calculated in this manner correlates with the roughness measured using AFM, it is clear that it conforms to the actual surface morphology.

### <Source of occurrence of short step bunching>

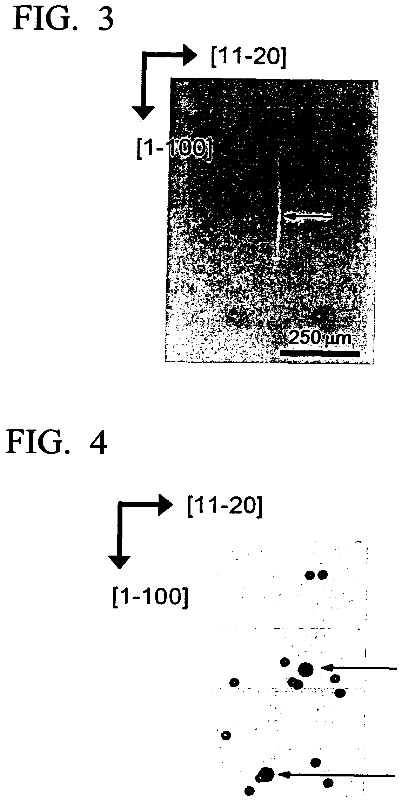

Fig. 3 shows the results of observation by differential interference microscope of an SiC epitaxial wafer for which short step bunching was observed by the optical surface inspection device. As shown by the arrow mark, a pronounced shallow pit and the concomitant short step bunching can be confirmed. The depth of the shallow pit in the surface of the epilayer was 6.3 nm.

Furthermore, Fig. 4 shows the results of observation by differential interference microscope after conduct of KOH etching for purposes of confirming the origin of this shallow pit. As portions thereof are shown by the arrow marks, the existence of spiral dislocations and the concomitant short step bunching can be confirmed. From this, it may be inferred that the short step bunching arose as a result of blockage of step flow growth by the unevenness of the shallow pit occurring in the surface. In this manner, it can be understood that the origin of occurrence of the short step bunching is the shallow pit deriving from a spiral dislocation in the epilayer passed on from the substrate.

As described above, by conducting observation/evaluation of an SiC epitaxial film surface by combining an optical surface inspection device with a surface inspection device that differs from a conventional wide-range observation type AFM, the present inventors discovered that this short step bunching exists as a standard condition of the surface, rather than as a peculiar condition thereof. As a result of diligent research, the present inventors then elucidated the origin of this short step bunching, and devised a method for manufacture of a step-bunching-free SiC epitaxial wafer that inhibits occurrence thereof.

It appears that the existence of this short step bunching is one of the primary causes of quality irregularities.

With respect to step bunching, a short step bunching was discovered which differs from conventional step bunching and its source of origin, and which originates in the SiC single crystal substrate. Discovery was also made of the conditions required in the substrate polishing process for purposes of reducing this substrate-derived short step bunching in addition to conventional step bunching. If an SiC single crystal substrate is cleaned by performing gas etching on an SiC single crystal substrate polished under these conditions, and if this SiC single crystal substrate is used, it was found that conventional step bunching and short step bunching are markedly reduced by conducting film formation by simultaneously supplying to the substrate surface in a prescribed concentration ratio the amounts of carbon-containing gas and silicon-containing gas required for epitaxial growth of silicon carbide. Furthermore, it was found that a step-bunching-free SiC epitaxial wafer can be obtained by simultaneously stopping supply, by maintaining substrate temperature until evacuation of the gas, and by subsequently decreasing the temperature.

The present invention provides the following means.
[1] An SiC epitaxial wafer manufacturing method which forms an SiC epitaxial layer on a 4H-SiC single crystal substrate tilted with an off angle of 0.4°-5° in the <11-20> axis direction relative to the (0001) surface of the 4H-SiC single crystal substrate, wherein
   silicon-containing gas and carbon-containing gas are simultaneously supplied so that a C/Si atom number ratio of carbon and silicon in an amount required for epitaxial growth of silicon carbide is 0.7-1.2 on said substrate whose surface has been cleaned by gas etching, and silicon carbide film is epitaxially grown at a temperature of more than 1600°C and 1800°C or less, wherein the term "simultaneously supplied" does not necessarily signify that supply is conducted at exactly the same time, but that it is conducted with a difference within 5 seconds,
   and epitaxial growth of said silicon carbide film is conducted: (1) in the case of use of a 4H-SiC single crystal substrate with an off angle of 0.4°-2°, at a growth rate of 1-3 µm/h when a growth temperature at which silicon carbide film is epitaxially grown is >1600-1640°C, at a growth rate of 3-4 µm/h when growth temperature is 1640-1700°C, and at a growth rate of 4-10 µm/h when growth temperature is 1700-1800°C; and (2) in the case of use of a 4H-SiC single crystal substrate with an off angle of 2°-5°, at a growth rate of 2-4 µm/h when a growth temperature at which silicon carbide film is epitaxially grown is >1600-1640°C, at a growth rate of 4-10 µm/h when growth temperature is 1640-1700°C, and at a growth rate of 10-20 µm/h when growth temperature is 1700-1800°C.
[2] The SiC epitaxial wafer manufacturing method according to [1], further comprising:
   a process in which the 4H-SiC single crystal substrate is prepared whose primary surface is machined into convex form at room temperature, and that has an off angle of 0.4°-5°, before the step in which the silicon carbide film is epitaxially grown.
[3] The SiC epitaxial wafer manufacturing method according to [2], wherein a radius of curvature of said convexity is in a range from 10 m or more to 1000 m or less.
[4] The SiC epitaxial wafer manufacturing method according to any one of [1] to [3], comprising a process wherein polishing is conducted until a lattice disorder layer of a surface of said 4H-SiC single crystal substrate is 3nm or less, prior to cleaning of the surface by said gas etching.
[5] The SiC epitaxial wafer manufacturing method according to any one of [1] to [3], wherein said gas etching is conducted in a hydrogen atmosphere at a temperature of 1400-1800°C.
[6] The SiC epitaxial wafer manufacturing method according to [5], wherein said gas etching is conducted with addition of silicon-containing gas and/or carbon-containing gas to said hydrogen atmosphere.

Here, "primary surface" signifies the surface on which epitaxial film is grown with respect to a 4H-SiC single crystal substrate.

"Film thickness distribution" and "carrier concentration distribution" are obtained from {(maximum value - minimum value) / (maximum value + minimum value)} x 100 (%) using samples from multiple sites on the wafer.

The appropriate range for the radius of curvature of the convexity will depend on the size of the 4H-SiC single crystal substrate, but a range of 7.62-10.16 cm (3-4 inches) is assumed here.

Given that desorption (sublimation) of Si and C from the substrate as well as their adsorption (growth) occur simultaneously on the surface of a substrate whose temperature has been raised, and given that there is a pattern of gas etching when desorption amount > adsorption amount, and growth when desorption amount < adsorption amount, the expression "...an amount required for epitaxial growth of silicon carbide..." is used to clarify the differential with the supply amounts of silicon-containing gas and/or carbon-containing gas during gas etching, because the amounts of silicon-containing gas and/or carbon-containing gas are small when addition of these raw material gases is conducted during gas etching, because superior gas etching is produced assuming that raw material gas is added.

### EFFECTS OF THE INVENTION

According to the foregoing configuration, it is possible to offer a step-bunching-free SiC epitaxial wafer of particularly high quality compared to conventional wafers, which reduces triangular defects and stacking faults, which improves uniformity of carrier concentration and film thickness, and which has no step bunching over the entire surface of the wafer, and a method of manufacture thereof

By fabricating an electronic device using a high-quality SiC epitaxial wafer of the foregoing configuration which has few triangular defects and stacking faults, which has satisfactory in-plane uniformity, and which is free of step bunching, the effects of property stability and property enhancement of the electronic device, as well as yield improvement are obtained.

By conducting epitaxial growth of silicon carbide film (1) in the case of use of a 4H-SiC single crystal substrate with an off angle of 0.4°-2° such that the growth rate is 1-3 µm/h when the growth temperature at which silicon carbide film is epitaxially grown is 1600-1640°C, the growth rate is 3-4 µm/h when growth temperature is 1640-1700°C, and the growth rate is 4-10 µm/h when growth temperature is 1700-1800°C, and (2) in the case of use of a 4H-SiC single crystal substrate with an off angle of 2°-5° such that the growth rate is 2-4 µm/h when the growth temperature at which silicon carbide film is epitaxially grown is 1600-1640°C, the growth rate is 4-10 µm/h when growth temperature is 1640-1700°C, and the growth rate is 10-20 µm/h when growth temperature is 1700-1800°C, the effect is obtained that an SiC epitaxial wafer is produced wherein the density of triangular-shaped defects in the surface of the SiC epitaxial layer is 1 defect/cm² or less, and the density of stacking faults in the SiC epitaxial wafer layer is 1 fault/cm² or less.

### BRIEF DESCRIPTION OF THE DRAWINGS

Fig. 1 is images of measurement of step bunching on an SiC epitaxial wafer surface by a normal AFM, images which show (a) conventional step bunching and (b) short step bunching.
Fig. 2 is images of measurement of step bunching on an SiC epitaxial wafer surface by a wide-range observation type AFM, images which show (a) conventional step bunching and (b) short step bunching.
Fig. 3 is an image of measurement by differential interference microscope of an SiC epitaxial wafer containing short step bunching.
Fig. 4 is an image of measurement by differential interference microscope of the wafer used in Fig. 3 after KOH etching.
Fig. 5 is images of measurement of an Si surface of an SiC epitaxial wafer with an off angle of 4° by a wide-range observation type AFM, images which show (a) an SiC epitaxial wafer produced by the method of the present invention and (b) a conventional SiC epitaxial wafer.
Fig. 6 is images of measurement of an Si surface of an SiC epitaxial wafer with an off angle of 4° by an optical surface inspection device using laser light, images which show (a) an SiC epitaxial wafer produced by the method of the present invention and (b) a conventional SiC epitaxial wafer.
Fig. 7 is images of measurement of an Si surface of an SiC epitaxial wafer with an off angle of 4° by a photoluminescence imaging device, images which show (a) an SiC epitaxial wafer produced by the method of the present invention and (b) a conventional SiC epitaxial wafer.
Fig. 8 is (a) an image and (b) a defect map, which measure a C surface of a conventional SiC epitaxial wafer with an off angle of 0.8° by an optical surface inspection device using laser light.
Fig. 9 is (a) an image and (b) a defect map, which observe a C surface of an SiC epitaxial wafer produced by the method of the present invention with an off angle of 0.8° by an optical surface inspection device using laser light.
Fig. 10 is images of measurement of a C surface of an SiC epitaxial wafer with an off angle of 0.8° by a photoluminescence imaging device, images which show (a) an SiC epitaxial wafer produced by the method of the present invention and (b) a conventional SiC epitaxial wafer.
Fig. 11 is a cross-sectional schematic view which shows an example of the film formation apparatus used in the manufacturing method of the present invention.
Fig. 12(a) is an image of measurement by a transmission electron microscope of a cross-section of an SiC single crystal substrate surface pertaining to the present invention, and Fig. 12(b) is an enlarged image of Fig. 12(a).
Fig. 13(a) is an image of measurement by a transmission electron microscope of a cross-section of a conventional SiC single crystal substrate surface, and Fig. 13(b) is an enlarged image of Fig. 13(a).
Fig. 14 pertains to the SiC epitaxial wafer surface of comparative example 2, wherein (a) is an image of measurement by an optical surface inspection device using laser light, and (b) is an image of observation by a wide-range observation type AFM.

### MODE FOR CARRYING OUT THE INVENTION

Below, an SiC epitaxial wafer and its method of manufacture which constitutes an embodiment of the present invention are described in detail using drawings.

### SiC epitaxial wafer

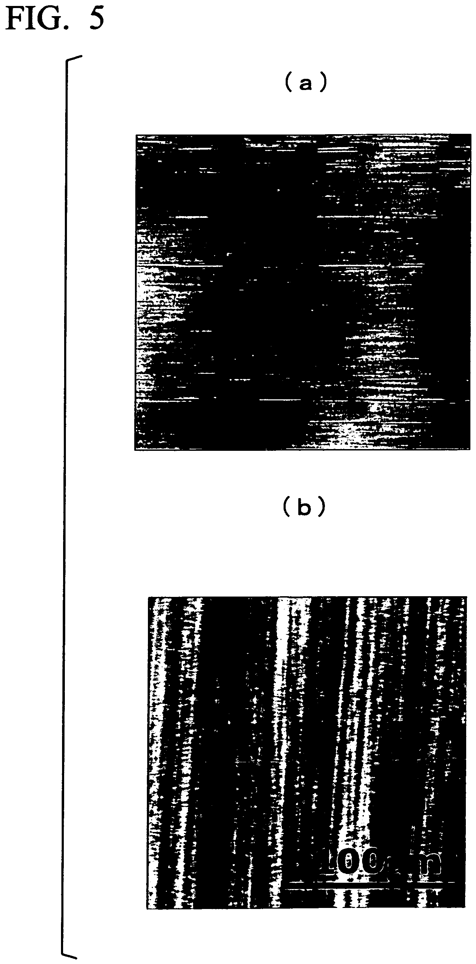

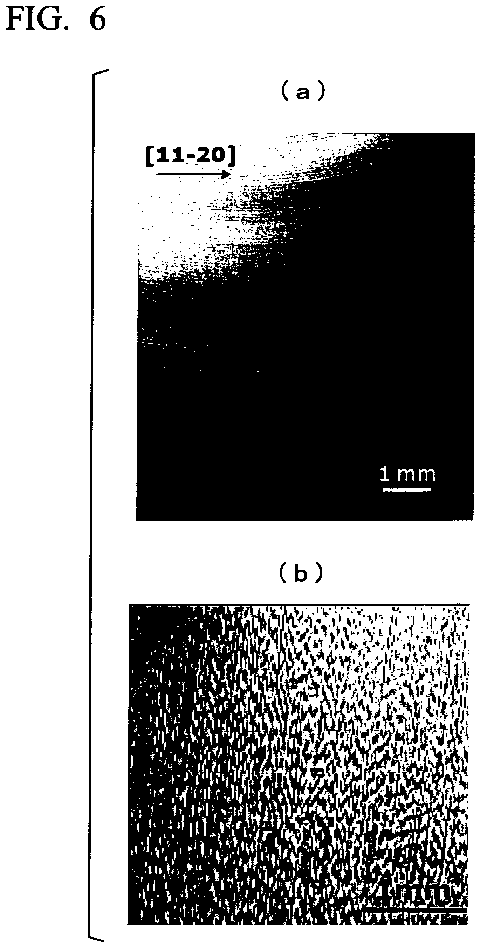

Fig. 5 and Fig. 6 show results of observation by a wide-range observation type AFM and by an optical surface inspection device using laser light (Candela CS20 manufactured by KLA-Tencor Corporation) of an SiC epitaxial wafer produced by the method of the present invention, wherein an SiC epitaxial layer is formed on the Si surface of a 4H-SiC single crystal substrate tilted with an off angle of 4°.

Fig. 5(a) is a wide-range observation type AFM image of 200 µm square of a surface of an SiC epitaxial wafer produced by the method of the present invention. Fig. 5(b) is a wide-range observation type AFM image of 200 µm square of a surface of a conventional SiC epitaxial wafer.

In the AFM image of an SiC epitaxial wafer produced by the method of the present invention, no steps whatsoever are observed (linear density of steps: 0/mm⁻¹). With respect also to other regions of this sample, scarcely any steps are observed. Accordingly, it is clear that a step-bunching-free wafer is achieved, and that the linear density of steps is 5 mm⁻¹ or less. In addition, the root-mean-square roughness Rq of the surface is 0.5 nm, and its maximum height difference Ry is 0.8 nm. The average Rq of three regions selected at random from the same sample is 0.41 nm, and the average Ry is 0.82 nm. Accordingly, it is clear that the root-mean-square roughness Rq of the observed surface is 1.0 nm or less, and its maximum height difference Ry is 3.0 nm or less.

In contrast, with the conventional SiC epitaxial wafer, step bunching was observed wherein numerous steps had united in a linear density of 340/mm⁻¹. The average of step linear density in three other regions from this sample was 362/mm⁻¹. It is clear that the steps extend beyond the range of observation.

In addition, the root-mean-square roughness Rq of the surface is 2.4 nm, and its maximum height difference Ry is 3.6 nm. The average Rq of three regions selected at random from the same sample is 3.2 nm, and the average Ry is 4.5 nm.

Fig. 6 (a) and (b) respectively show images of observation by an optical surface inspection device using laser light (hereinafter "Candela images") pertaining to a range of 1 mm square of the same samples as Fig. 5 (a) and (b).

The root-mean-square roughness Rq of the observed surface is 0.54 nm with the SiC epitaxial wafer produced by the method of the present invention. In contrast, it is 1.7 nm with the conventional SiC epitaxial wafer, evidencing a clear difference in surface planarity between the SiC epitaxial wafer produced by the method of the present invention and the conventional one.

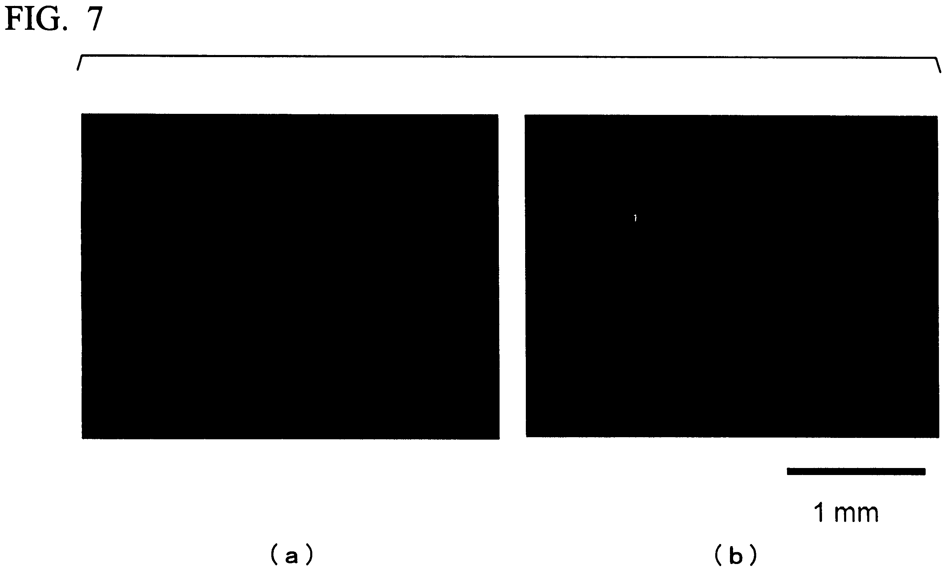

Fig. 7(a) shows a PL image obtained by using a photoluminescence imaging device (PLI-100 manufactured by Photon Design Corporation) to observe an SiC epitaxial wafer produced by the method of the present invention in which an SiC epitaxial layer is formed on an Si surface of a 4H-SiC single crystal substrate tilted with an off angle of 4°. Fig. 7(b) shows a PL image obtained by using a photoluminescence imaging device (PLI-100 manufactured by Photon Design Corporation) to observe an SiC epitaxial wafer in which an SiC epitaxial layer is formed by a conventional method on an Si surface of a 4H-SiC single crystal substrate tilted with an off angle of 4°.

In the SiC epitaxial wafer produced by the method of the present invention shown in Fig. 7(a), triangular-shaped light emission/absorption is not observed, and stacking faults do not exist. When measurement was conducted over the entire wafer area, stacking fault density was 0 faults/cm².

In contrast, in the SiC epitaxial wafer obtained by a conventional method shown in Fig. 7(b), one case of triangular-shaped light emission/absorption is observed, and stacking faults exist. When measurement was conducted over the entire wafer area, stacking fault density was 2.8 faults/cm².

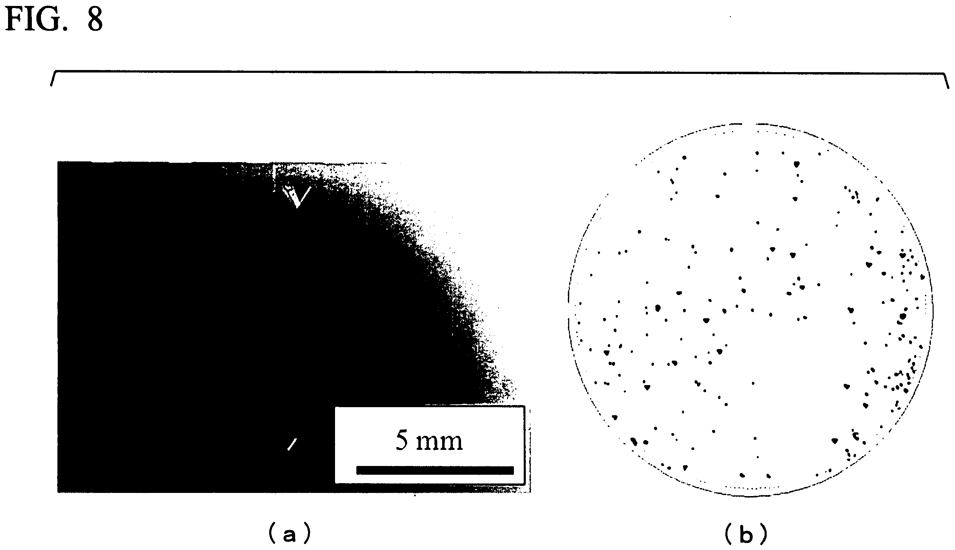

Fig. 8 (a) and (b) show results (a Candela image (a) and a defect map (b) based on the Candela image) obtained by using an optical surface inspection device (Candela CS20 manufactured by KLA-Tencor Corporation) to observe an SiC epitaxial wafer in which an SiC epitaxial layer is formed by a conventional method on a C surface of a 4H-SiC single crystal substrate tilted with an off angle of 0.8°.

In the wide-range Candela image of 10 mm × 15 mm shown in Fig. 8(a), three triangular defects are observed. In the defect map of the entire wafer surface shown in Fig. 8(b), triangular defect density is 3.1/cm² (defect density including triangular defects is 4/cm²), and triangular defects exist over the entire wafer area.

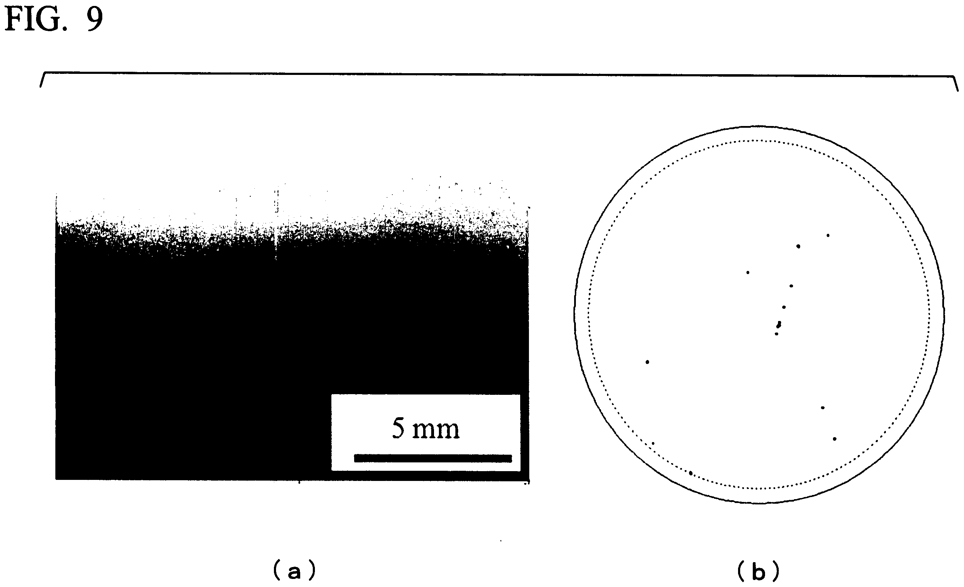

Fig. 9 (a) and (b) show results obtained by using an optical surface inspection device (Candela CS20 manufactured by KLA-Tencor Corporation) to observe an SiC epitaxial wafer produced by the method of the present invention, in which an SiC epitaxial layer is formed on a C surface of a 4H-SiC single crystal substrate tilted with an off angle of 0.8°.

In the wide-range Candela image of 10 mm × 15 mm shown in Fig. 9(a), no triangular defects whatsoever are observed. In the defect map of the entire wafer surface shown in Fig. 9(b), triangular defect density is 0.4/cm² (defect density including triangular defects is 1.2/cm²), evidencing a marked reduction compared to the conventional SiC epitaxial wafer shown in Fig. 8. The reduction in the peripheral region of the wafer is particularly large. This would seem to be a result obtained by conducting epitaxial growth in a state where the concavity (warp) of the substrate is reduced during epitaxial growth using a 4H-SiC single crystal substrate whose primary surface was machined into a convexity. By machining a convexity with an optimal radius of curvature, it would seem that defect density in the central portion would be further reduced.

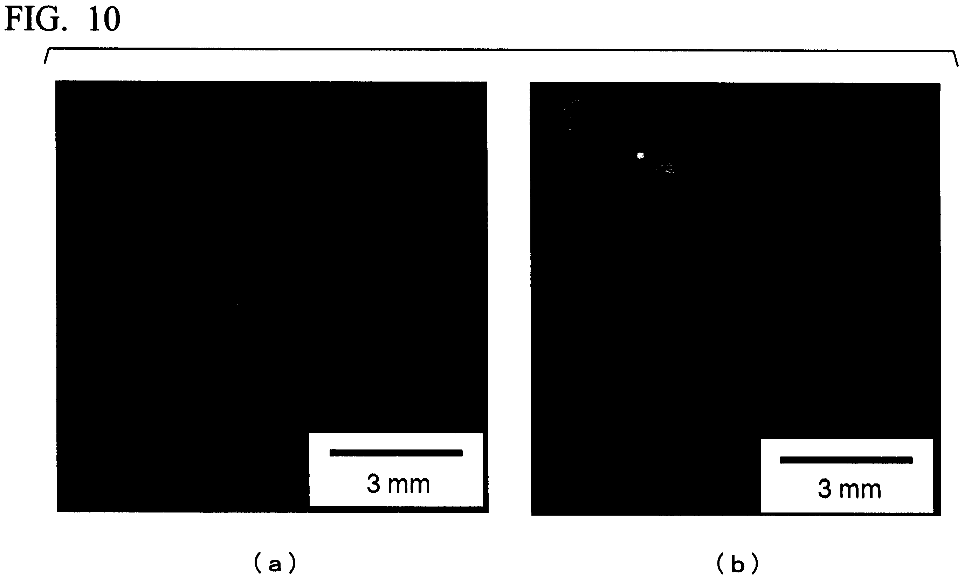

Fig. 10(a) shows a PL image obtained by using a photoluminescence imaging device (PLI-100 manufactured by Photon Design Corporation) to observe the SiC epitaxial wafer produced by the method of the present invention shown in Fig. 9. Fig. 10(b) is a PL image of the SiC epitaxial wafer fabricated by a conventional method shown in Fig. 8. In the SiC epitaxial wafer produced by the method of the present invention shown in Fig. 10(a), triangular-shaped light emission/absorption is not observed, and stacking faults do not exist. When measurement was conducted over the entire wafer area, stacking fault density was 0.1 faults/cm².

In contrast, in the SiC epitaxial wafer obtained by a conventional method shown in Fig. 10(b), three cases of triangular-shaped light emission/absorption are observed, and stacking faults exist. When measurement was conducted over the entire wafer area, stacking fault density was 1.8 faults/cm².

### SiC epitaxial film formation apparatus

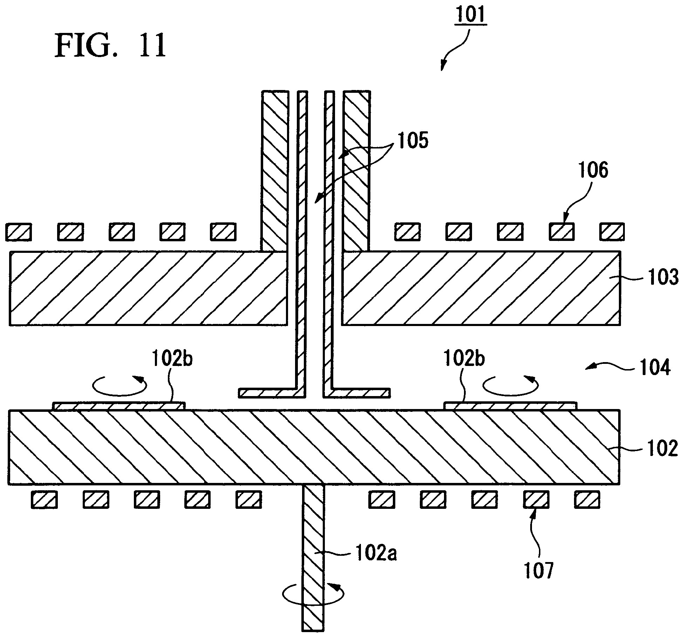

Fig. 11 is a schematic view of one example of a film formation apparatus for SiC epitaxial wafer film produced by the method of the present invention.

This silicon carbide film formation apparatus 101 is provided with a reaction chamber 104 disposed between a planetary 102 supported by multiple wafer installation pieces 102b and a thermal radiation member 103, a gas supply portion 105 which supplies gas to the interior of the reaction chamber 104 through the central portion of the thermal radiation member 103, and high-frequency coils 106 and 107 which respectively heat the planetary 102 and the thermal radiation member 103.

A revolving rotary shaft 102a is disposed directly underneath the gas supply portion 105.

According to this configuration, an SiC single crystal wafer is rotated by the planetary 102 with the gas supply portion 105 as the central axis at a rotational speed of, for example, 5-20 rpm, and the SiC single crystal wafer itself is spun around the center of the SiC single crystal wafer by the wafer installation pieces 102b at a rotational speed of, for example, 50-200 rpm.

By conducting autorotation of the wafer installation pieces 102b and the planetary 102 in this manner, a configuration is obtained wherein the in-plane uniformity of the film thickness, carrier concentration, and temperature distribution of the SiC wafer is improved.

Moreover, by means of a configuration wherein high-frequency coils 106 and 107 are disposed above and below the reaction chamber 104, the substrate can be heated to a high temperature.

The growth surface (front surface) of the SiC wafer that is formed into a convexity is set facing upward in the wafer installation pieces 102b. When the SiC wafer is heated during growth of the epitaxial film, a temperature difference arises between the front surface and rear surface of the SiC wafer. This is because the front surface of the substrate is cooled by the gas supplied from the gas supply portion 105. Consequently, during epitaxial film growth, the substrate warps due to a thermal expansion difference originating in the temperature difference of the front surface and rear surface, with the result that a portion of the SiC wafer rises up from the wafer installation pieces 102b, and imparted heat is not uniformly transmitted to the entire SiC wafer.

### Method of manufacture of SiC epitaxial wafer

The particulars of an SiC epitaxial wafer manufacturing method which is an embodiment applying the present invention are described below.

### <Convexity machining process>

The fabrication of an SiC single crystal substrate (wafer) begins from the slicing of a 4H-SiC ingot manufactured by a method such as sublimation.

Slicing is ordinarily conducted by an inner peripheral blade or wire saw, and in recent years, a wire saw with good mass production capability has come into common use.

In the case where convexity machining is conducted, the convexity machining is conducted at the stage of this slicing.

Specifically, by setting the wire deflection amount at the time of cutting to 2 mm or more, and by tilting by several degrees an angle formed by a plane that includes a line constituting the reciprocating direction of the wire with a vertical plane relative to the outer periphery of the cylindrical ingot, the form of at least one surface of an SiC single crystal wafer that is cut out from the ingot can be machined into a convexity. At this time, by setting the angle within a range from 1° or more to 3° or less, the radius of curvature of the convexity is within a range from 10 m or more to 1000 m or less. With respect to the direction of the convexity, its angle of inclination is varied so that it becomes the surface used as the epitaxial surface.

The SiC single crystal substrate that has been machined into a convex (curved, warped) shape is preferably given a continuous and uniform convexity on its primary surface. A continuous and uniform convexity signifies a smooth condition without angularities, where there are no partial concavities. It is preferable that the radius of curvature of the convexity be in a range from 10 m or more to 1000 m or less. This is because, when it is 10 m or less, the concavity of the primary surface at room temperature cannot be sufficiently reduced by thermal expansion during epitaxial growth, and when it is 1000 m or more, the effect of convexity (curvature) machining cannot be sufficiently obtained.

There are several methods for measuring and quantifying the size of the convexity (curvature, warp). For example, the radius of curvature of the convexity (curvature, warp) can be determined from the warp that is measured by a wafer planarity measurement analyzer (e.g., Ultrasort manufactured by SOL Corporation). With respect to the measurement method, using a focal plane as the reference plane, the warp is defined by the total of the maximum values of deviation in the vertical direction from that plane, in a state where the wafer is free from chucking. This is one of the commonly used indicators when quantifying the warp of a wafer. In the case where the wafer shape is a simple shape such as a convexity that projects uniformly upward, the measurement values of the warp conform to the warp values of the common definition.

With respect to the SiC single crystal substrate, it is acceptable to use either one wherein the primary surface is curved, or one wherein the SiC single crystal substrate itself is convexly warped toward the primary surface, and it is also acceptable to form one wherein the primary surface is curved and the SiC single crystal substrate itself is convexly warped.

### <Polishing process>

With respect to the polishing process, a 4H-SiC single crystal substrate which remains on a wafer surface in the slicing process is subjected to polishing until the lattice disorder layer of the surface is 3 nm or less.

A "lattice disorder layer" signifies, as stated above, a layer corresponding to an atomic layer (lattice) of an SiC single crystal wherein the striped structure or a portion of the stripes is unclear in a TEM lattice image (an image capable of confirming the lattice).

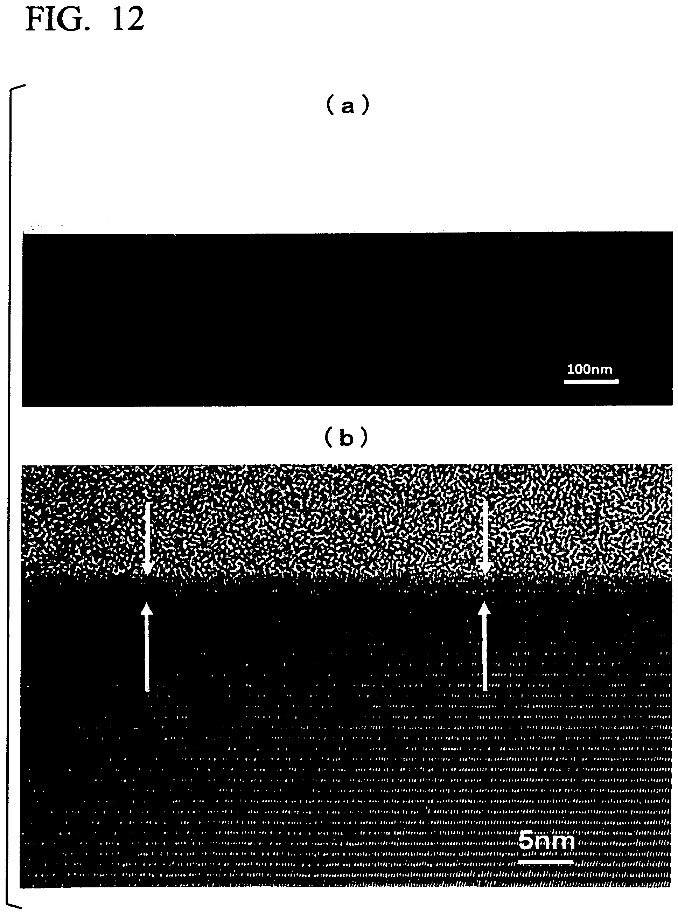

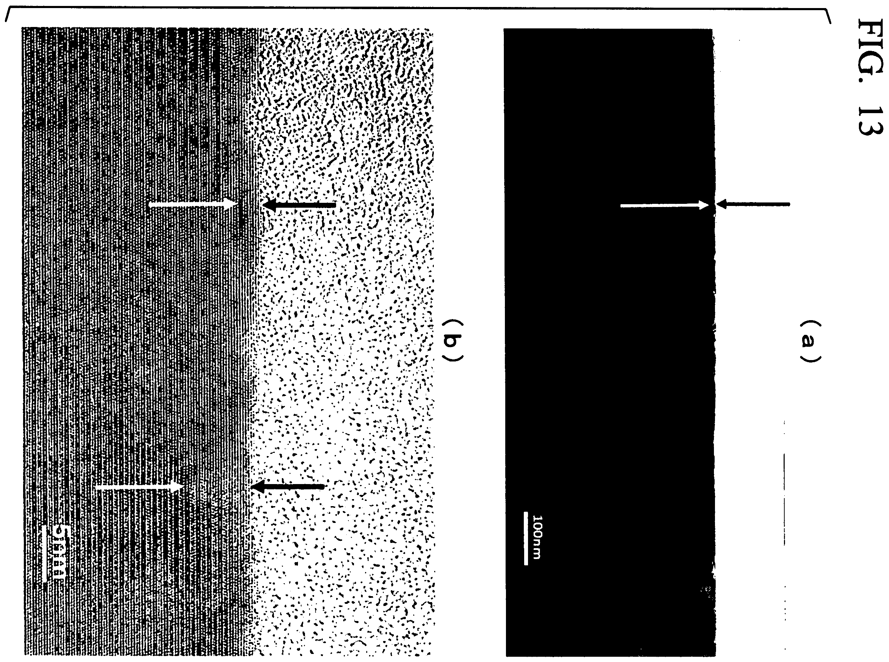

First, in order to describe the existence and features of a "lattice disorder layer," Fig. 12 and Fig. 13 show transmission electron microscope (TEM) images of the vicinity of the surface of an SiC single crystal substrate after the polishing process.

Fig. 12 (a) and (b) are TEM images which show an example of an SiC single crystal substrate produced by the method of the present invention.

Surface planarity disorder cannot be observed in the TEM image shown in Fig. 12(a). In the lattice image which is an enlarged image (Fig. 12(b)), disorder is observed only in the atomic layer (lattice) of the uppermost layer, and a clear striped structure can be observed from the underlying atomic layer (lattice). The layer sandwiched by the arrow marks is the "lattice disorder layer."

From this TEM image, it can be confirmed that the "lattice disorder layer" of the surface is 3 nm or less.

Fig. 13 (a) and (b) are TEM images which show an example of an SiC single crystal substrate wherein a lattice disorder layer of 3 nm or more exists in the surface.

Surface planarity disorder can clearly be observed in the TEM image shown in Fig. 13(a). Even with respect to the portion which appears flat in Fig. 13(a), a disorder in the striped structure can be observed that extends across 6 nm or more from the surface in the lattice image which is an enlarged image thereof (Fig. 13(b)).

A "lattice disorder layer" on the order of 7 nm can be observed in this TEM image (the layer sandwiched by the arrow marks on the right side of the image), and it is clear with this sample that the "lattice disorder layer" in the surface does not reach 3 nm or less.

An embodiment of this process is described below.

The polishing process ordinarily includes multiple polishing steps such as rough polishing called "lapping," precision polishing called "polishing," and chemical mechanical polishing (hereinafter "CMP") which is ultra-precision polishing.

The polishing process is often conducted wet. What is common to this process is that it is conducted by applying a polishing head to which a silicon carbide substrate adheres while supplying a polishing slurry to a rotating plate to which a polishing cloth is affixed. The polishing slurry used in the present invention is basically used in this mode, but there are no limitations on the mode provided that it is wet polishing that uses a polishing slurry.

There are no limitations on the particles used as abrasive grain provided that the particles disperse without dissolution in this pH region. In the present invention, it is preferable that the pH of the polishing solution be less than 2. In this case, diamond, silicon carbide, aluminum oxide, titanium oxide, silicon oxide and so on can be used as the polishing particles. In the present invention, polishing particles with an average size of 1-400 nm, preferably 10-200 nm, and more preferably 10-150 nm are used as the abrasive grain. From the standpoints of small grain size and commercial availability at low cost, silica is well-suited to obtainment of a satisfactory final finishing surface, and colloidal silica is more preferable. The particle size of the polishing agent such as colloidal silica can be suitably selected according to machining properties such as machining speed and surface roughness. In cases where higher polishing speeds are required, polishing material of larger particle size may be used. When surface roughness is small - i.e., when a smooth high-grade surface is required - polishing material of small particle size may be used. Material where average particle size exceeds 400 nm is uneconomical, because it is expensive, and cannot attain high polishing speeds. Polishing speed markedly declines with extremely small material which has a particle size of less than 1 nm.

The additive amount of polishing particles is 1 mass %-30 mass %, and preferably 1.5 mass %-15 mass %. When 30 mass % is exceeded, the drying speed of the polishing particles quickens, heightening the risk of causing scratches, and it is uneconomical. With polishing particles which are less than 1 mass %, machining speed tends to excessively decline, which is undesirable.

The polishing slurry used in the present invention is an aqueous polishing slurry. The pH at 20°C is less than 2.0, preferably less than 1.5, and more preferably less than 1.2. In regions where pH is 2.0 or more, sufficient polishing speed is not obtainable. On the other hand, by setting the pH of the slurry to less than 2, chemical reactivity relative to silicon carbide markedly increases even in an ordinary indoor environment, enabling ultra-precision polishing. Silicon carbide is not directly removed by the mechanical action of oxide particles in the polishing slurry, and it is thought that there is a mechanism whereby the reaction solution causes the silicon carbide single crystal surface to chemically react with silicon oxide, with the silicon oxide being removed by the mechanical action of the abrasive grain. Accordingly, to obtain a smooth surface without scratch marks or machining-affected layers, it is extremely important to have a polishing solution composition with a liquid phase that facilitates reaction of silicon carbide - i.e., a pH of less than 2 - and to select oxide particles having appropriate hardness as abrasive grain.

The polishing slurry is adjusted to a pH of less than 2 using at least one acid, and preferably two or more acids. As acids, inorganic acid is preferable; as inorganic acids, hydrochloric acid, nitric acid, phosphoric acid, and sulfuric acid are preferable. It is unclear why use of multiple acids is effective, but it has been experimentally confirmed, and it is possible that the multiple acids interact to heighten the effect. As to the additive amount of the acid, the type and amount may be suitably selected -for example, in a range of 0.5-5 mass % for sulfuric acid, 0.5-5 mass % for phosphoric acid, 0.5-5 mass % for nitric acid, and 0.5-5 mass % for hydrochloric acid - so that pH is less than 2.

The reason why inorganic acid is effective is that it is stronger acid than organic acid, and is extremely expedient for purposes of adjusting the polishing solution to a prescribed strong acidity. Use of organic acid for adjustment of strongly acidic polishing solution is fraught with difficulties.

The polishing of silicon carbide is conducted by removing the oxide layer by oxide particles by means of reactivity with the oxide film produced on the surface of the silicon carbide by the strongly acidic polishing solution. When oxidizing agents are added to the polishing slurry in order to accelerate this surface oxidation, greater effectiveness is exhibited. As oxidizing agents, one may cite hydrogen peroxide, perchloric acid, potassium dichromate, and ammonium sulfate persulfate. For example, polishing speed is improved by adding 0.5-5 mass %, and preferably 1.5-4 mass % of hydrogen peroxide water, but the oxidizing agent is not limited to hydrogen peroxide water.

With respect to the polishing slurry, a gelling prevention agent may be added in order to inhibit gelling of the polishing material. As to the type of gelling prevention agent, chelating agents of ester phosphate may be suitably used such as 1-hydroxyethylidene-1,1-diphosphonic acid and amino triethylene phosphonic acid. The gelling prevention agent may be added in a range of 0.01-6 mass %, and preferably 0.05-2 mass %.

To set the lattice disorder layer of the surface at 3 nm or less in the polishing process of the present invention, it is preferable to suppress the damage layer to 50 nm by setting machining pressure at 350 g/cm² or less and by using abrasive grain with a diameter of 5 µm or less in mechanical polishing prior to CMP. Furthermore, in CMP, it is preferable that the polishing slurry contain inorganic acid and polishing particles with an average particle size of 10 nm-150 nm, and have a pH of less than 2 at 20°C; it is also preferable that the polishing particles be silica contained in a range from 1 mass % to 30 mass %; and it is more preferable that the inorganic acid be at least one among hydrochloric acid, nitric acid, phosphoric acid, and sulfuric acid.

### <Cleaning (gas etching) step>

In the cleaning step, the substrate after the aforementioned polishing and convexity machining is heated to 1400-1800°C in a hydrogen atmosphere, and the surface thereof is subjected to cleaning (gas etching).

An embodiment of this process is described below.

Gas etching is conducted for 5-30 minutes, while maintaining the SiC single crystal substrate at 1400-1800°C, and setting the hydrogen gas flow rate at 40-120 slm and pressure at 100-250 mbar.

After cleaning of the SiC single crystal substrate after polishing, the substrate is set up inside an epitaxial growth apparatus such as a multiple-sheet planetary type CVD apparatus of the mass production type. After introduction of hydrogen gas into the apparatus, pressure is adjusted to 100-250 mbar. Subsequently, the temperature of the apparatus is raised, substrate temperature is set at 1400-1600°C (preferably at 1480°C or higher), and gas etching of the substrate surface is conducted by hydrogen gas for 1-30 minutes. When gas etching was conducted by hydrogen gas under these conditions, the etching amount was on the order of 0.05-0.4 µm.

It would seem that the substrate surface sustains damage during the polishing process, and that there is not only damage detectable as a "lattice disorder layer" by TEM, but also lattice strains and the like that exist more deeply and that are not detectable by TEM. The purpose of gas etching is to remove the layers that have sustained such damage (hereinafter "damage layers"). When gas etching is insufficient and damage layers remain, heterogeneous polytypes as well as dislocations, stacking faults and the like are introduced into the epitaxial growth layer. When etching is excessively conducted, a surface reconfiguration of the substrate surface is produced, and step bunching occurs prior to the start of epitaxial growth. Consequently, it is important to optimally match the damage layers and the gas etching amount. As sufficient conditions for the manufacture of a step-bunching-free SiC epitaxial wafer, the present inventors discovered as a result of diligent research a combination of the aforementioned gas etching conditions and damage layers when the lattice disorder layer of the substrate surface is thinned to 3 nm or less.

With respect to the substrate surface after the cleaning (gas etching) process, it can be confirmed using an optical surface inspection device that the root-mean-square roughness Rq of the uppermost surface of the epitaxial layer is 1.3 nm or less when a region that is 35% or more of the entire surface is analyzed. Measurement using an atomic force microscope is able to confirm that it is 1.0 nm or less with 10 µm square, 1.0 nm or less with 200 µm square, and that the maximum height difference Ry for step bunching (short step bunching) with a length of 100-500 µm that is observed in 200 µm square is 3.0 nm or less. It can also be confirmed that the linear density of this step is 5 mm⁻¹ or less.

In the film formation process and temperature decrease process following this, it is important to maintain the planarity of the substrate surface.

SiH₄ gas and/or C₃H₈ gas can also be added to the hydrogen gas. There are cases where short step bunching occurs in association with shallow pits originating in spiral dislocations. By conducting gas etching with addition of SiH₄ gas in a concentration of less than 0.009 mol % to the hydrogen gas in order to create an Si rich environment within the reactor, the depth of shallow pits can be made shallower, and occurrence of short step bunching associated with shallow pits can be inhibited.

In the case where SiH₄ gas and/or C₃H₈ gas is added, it is preferable to conduct temporary evacuation and establish a hydrogen gas atmosphere prior to the film formation (epitaxial growth) process.

### <Film formation (epitaxial growth) process>

In the film formation (epitaxial growth) process, SiH₄ gas and C₃H₈ gas are simultaneously supplied in a C/Si concentration ratio of 0.7-1.2 in the amount required for epitaxial growth of silicon carbide to the substrate surface after the aforementioned cleaning (after sublimation in the case where the growth temperature of the epitaxial film is higher than the cleaning (gas etching) temperature).

As stated above, "simultaneously supplied" does not necessarily signify that supply is conducted at exactly the same time, but that it is conducted with a difference within several seconds. In the case where the Hot Wall SiC CVD (VP2400HW) manufactured by Aixtron Corporation shown in the following working examples is used, it is possible to manufacture a step-bunching-free SiC epitaxial wafer if the supply time difference between the SiH₄ gas and C₃H₈ gas is within 5 seconds.

The individual flow rates, pressure, substrate temperature, and growth temperature of the SiH₄ gas and C₃H₈ gas are respectively 15-150 sccm, 3.5-60 sccm, 80-250 mbar, and more than 1600°C, and 1800°C or less, growth speed is within a range of 1-20 µm per hour, and these are determined while controlling the off angle, film thickness, carrier concentration uniformity, and growth speed. Carrier concentration in the epitaxial layer can be controlled by introducing nitrogen gas as a doping gas simultaneous with the start of film formation.

In order to increase migration of Si atoms in the growth surface as a method of inhibiting step bunching during growth, lowering the C/Si concentration ratio of the supplied raw material gas is known, and C/Si is 0.7-1.2 in the present invention. With respect to the epitaxial layer that is grown, ordinarily, thickness is on the order of 5-20 µm, and carrier concentration is on the order of 2-15 × 10¹⁵ cm⁻³.

With respect to the growth temperature and the growth rate according to the off angle of the SiC single crystal substrate, (1) in the case of use of a 4H-SiC single crystal substrate with an off angle of 0.4°-2°, the growth rate is 1-3 µm/h when the growth temperature at which silicon carbide film is epitaxially grown is 1600-1640°C, the growth rate is 3-4 µm/h when growth temperature is 1640-1700°C, and the growth rate is 4-10 µm/h when growth temperature is 1700-1800°C, and (2) in the case of use of a 4H-SiC single crystal substrate with an off angle of 2°-5°, the growth rate is 2-4 µm/h when the growth temperature at which silicon carbide film is epitaxially grown is 1600-1640°C, the growth rate is 4-10 µm/h when growth temperature is 1640-1700°C, and the growth rate is 10-20 µm/h when growth temperature is 1700-1800°C.

### <Temperature reduction process>

In the temperature reduction process, the supply of SiH₄ gas and C₃H₈ gas is simultaneously stopped, substrate temperature is maintained until the SiH₄ gas and C₃H₈ gas are evacuated, and the temperature is subsequently reduced.

After film formation, the supply of SiH₄ gas and C₃H₈ gas and the introduction of nitrogen gas as doping gas are stopped, and temperature is decreased. Even at this time, on the SiC epitaxial film surface, the surface morphology produced by gas etching can be degraded. In order to inhibit degradation of this surface morphology, the timing of supply stoppage of the SiH₄ gas and C₃H₈ gas, and the timing of temperature reduction are important. It was found that morphology degradation is inhibited by simultaneously stopping the supply of the SiH₄ gas and C₃H₈ gas, by subsequently maintaining the growth temperature until these supplied gases are eliminated from the substrate surface, and by subsequently lowering the temperature to room temperature at an average rate of 50°C per minute.

### WORKING EXAMPLES

The present invention is described in further detail below by means of working examples.

The present working examples use SiH₄ gas as the silicon-containing gas, C₃H₈ gas as the carbon-containing gas, N₂ gas as the doping gas, and H₂ gas as the carrier gas and the etching gas, and SiC epitaxial film is grown on an Si surface and a C surface which are slightly tilted in the <11-20> axis direction relative to the (0001) surface of the 4H-SiC single crystal by a Hot Wall SiC CVD (VP2400HW) manufactured by Aixtron Corporation which is a multiple-sheet planetary (autorotation) CVD apparatus of the mass production type.

### Si surface of 4H-SiC single crystal substrate with off angle of 4°

### (Working Example 1)

An SiC epitaxial layer was grown on the Si surface of a 4H-SiC single crystal substrate tilted at an off angle of 4°.

In the present working example, convexity machining is not conducted on the 4H-SiC single crystal substrate.

With respect to the polishing process, the mechanical polishing prior to CMP was conducted at a working pressure of 350 g/cm², using abrasive grain with a diameter of 5 µm or less. CMP was conducted for 30 minutes under conditions where silica particles with an average particle size of 10-150 nm were used as the polishing particles, sulfuric acid was included as the inorganic acid, and a polishing slurry with a pH of 1.9 at 20°C was used. By this means, the lattice disorder layer of the surface was 3 nm or less.

After polishing, the substrate was subjected to RCA cleaning, and subsequently introduced into the growth apparatus. RCA cleaning is a wet cleaning method which is commonly used on Si wafers, and is able to remove organic matter as well as heavy metal and particles of the substrate surface using a mixed solution of sulfuric acid/ammonia/hydrochloric acid and hydrogen peroxide water.

The cleaning (gas etching) process was conducted for 20 minutes at a hydrogen gas flow rate of 100 slm, an internal reactor pressure of 200 mbar, and a substrate temperature of 1500°C.

In the SiC epitaxial growth process, the substrate temperature was set at 1650°C, and simultaneous supply of 24 sccm of C₃H₈ gas and 8 sccm of SiH₄ gas was started so as to simultaneously supply SiH₄ gas and C₃H₈ gas to the primary surface of the substrate. 1.0 was selected as C/Si. The growth process was conducted for 2 hours at a growth rate of 5 µm/h with an internal reactor pressure of 200 mbar, and an SiC epitaxial layer with a thickness of 10 µm was grown.

With respect to the SiC epitaxial wafer manufactured in this manner, the results of measurement by a wide-range observation type AFM (Nanoscale Hybrid Microscope VN-8000 manufactured by Keyence Corporation), an optical surface inspection device (Candela CS20 manufactured by KLA-Tencor Corporation) and a photoluminescence imaging device (PLI-100 manufactured by Photon Design Corporation) are as respectively shown in Fig. 5(a), Fig. 6(a), and Fig. 7(a).

Rq measured by the optical surface inspection device was 1.2 nm, and Rq measured by the wide-range observation type AFM was 0.4 nm, and the maximum height difference Ry was 0.6 nm. No step bunching was observed.

Moreover, the triangular defect density of the epitaxial film surface of the SiC epitaxial wafer was 0.6 defects/cm², and stacking fault density in the epitaxial film of the SiC epitaxial wafer was 0 faults/cm².

### (Comparative Example 1)

The manufacturing conditions of the SiC epitaxial wafer were identical to those of Working Example 1, except that the substrate growth temperature was set at 1600°C.

With respect to the SiC epitaxial wafer manufactured in this manner, as a result of measurement by an optical surface inspection device (Candela CS20 manufactured by KLA-Tencor Corporation) and a photoluminescence imaging device (PLI-100 manufactured by Photon Design Corporation), triangular defect density of the SiC epitaxial wafer surface was 2.4 defects/cm², and triangular defect existed across the entire wafer area. Stacking fault density in the SiC epitaxial wafer film was 2.8 faults/cm², which was considerably larger than in Working Example 1 of the present invention.

From this comparison, it is clear that there exists a growth temperature which reduces defect density at a temperature that is higher than the upper limit (1600°C) of conventional growth temperature.

### Si surface of 4H-SiC single crystal substrate with off angle of 1.2°

### (Working Example 2)

An SiC epitaxial wafer was manufactured under the same manufacturing conditions as Working Example 1, except that the growth process was conducted for 2.5 hours at a growth rate of 4 µm/h.

The manufactured SiC epitaxial wafer was measured and evaluated by an optical surface inspection device (Candela CS20 manufactured by KLA-Tencor Corporation) and a photoluminescence imaging device (PLI-100 manufactured by Photon Design Corporation), and a wide-range observation type AFM (Nanoscale Hybrid Microscope VN-8000 manufactured by Keyence Corporation).

Triangular defect density was 0.4 defects/cm², and stacking fault density was 0.1 faults/cm². No step bunching was observed.

Both cases were under 1 defect or fault/cm², and even with respect to a 4H-SiC single crystal substrate with a 1.2° off angle lower than that of Working Example 1, extremely high quality epitaxial film of low defect density was formed.

### C surface of 4H-SiC single crystal substrate with off angle of 0.8°

### (Working Example 3)

Using a multi-wire saw, a C surface was subjected to slice machining into convex form so that the radius of curvature of the convexity was 50 m, and an SiC epitaxial wafer was manufactured under the same manufacturing conditions as Working Example 1, except that the growth process was conducted for 2.5 hours at a growth rate of 4 µm/h.

With respect to the manufactured SiC epitaxial wafer, the results of measurement by an optical surface inspection device (Candela CS20 manufactured by KLA-Tencor Corporation) and a photoluminescence imaging device (PLI-100 manufactured by Photon Design Corporation) are as respectively shown in Fig. 9. The triangular defect density was 0.4 defects/cm², and stacking fault density was 0.2 faults/cm². Both cases were under 1 defect or fault/cm², and even with respect to a C surface of a 4H-SiC single crystal substrate with a low off angle, extremely high quality epitaxial film of low defect density was formed.

Moreover, no step bunching was observed in measurement by an optical surface inspection device (Candela CS20 manufactured by KLA-Tencor Corporation) and a wide-range observation type AFM (Nanoscale Hybrid Microscope VN-8000 manufactured by Keyence Corporation).

Film thickness uniformity was measured using a mercury probe concentration analyzer (Hg-CV) (495CV System manufactured by SSSM Corporation), and carrier concentration uniformity was measured using a high-speed Fourier transform infrared ray absorption analyzer (FT-IR) (QS1200 manufactured by Nanometrics Corporation).

An SiC epitaxial layer was formed which had a film thickness uniformity of 2%, carrier concentration uniformity of 8%, and satisfactory in-plane uniformity. "Film thickness distribution" and "carrier concentration distribution" was obtained from {(maximum value - minimum value) / (maximum value + minimum value)} × 100 (%) using samples from 8 sites on the wafer. As film thickness uniformity was on the order of 5-10%, and carrier concentration uniformity was on the order of 15-20% when convexity machining was not conducted, the uniformity of film thickness and carrier concentration was improved by conducting convexity machining.

### (Comparative Example 2)

The manufacturing conditions of the SiC epitaxial wafer were identical to those of Working Example 3, except that the substrate growth temperature was set at 1600°C.

With respect to the SiC epitaxial wafer manufactured in this manner, the results of measurement by an optical surface inspection device (Candela CS20 manufactured by KLA-Tencor Corporation) and a photoluminescence imaging device (PLI-100 manufactured by Photon Design Corporation) are as shown in Fig. 8 and Fig. 10 (a). The triangular defect density of the SiC epitaxial wafer surface was 4 defects/cm², and triangular defect existed across the entire wafer area. Stacking fault density in the SiC epitaxial wafer film was 1.8 faults/cm², which was considerably larger than in Working Example 3 of the present invention.

From this comparison, it is clear that there exists a growth temperature which reduces defect density at a temperature that is higher than the upper limit (1600°C) of conventional growth temperature.

### Step bunching reduction effect

Next, the results of investigation of effects on step bunching reduction are shown with respect to the C/Si atom number ratio of carbon and silicon and the simultaneous supply of silicon-containing gas and carbon-containing gas.

For purposes of confirming the effects imparted by the foregoing two conditions, with respect to the SiC epitaxial wafers (samples) shown below, the growth temperature for epitaxial growth was 1600°C or less, and convexity machining was not conducted.

The present working example used SiH₄ gas as the silicon-containing gas, C₃H₈ gas as the carbon-containing gas, N₂ gas as the doping gas, and H₂ gas or HCl gas as the carrier gas and etching gas to grow SiC epitaxial film on an Si surface that is tilted 4° in the <11-20> axis direction relative to the (0001) surface of a 4H-SiC single crystal by means of a Hot Wall SiC CVD (VP2400HW) manufactured by Aixtron Corporation. The roughness of the obtained epitaxial wafer surface was investigated using an optical surface inspection device (Candela CS20 manufactured by KLA-Tencor Corporation), a normal AFM (Dimension V manufactured by Veeco Instrument Corporation), and a wide-range observation type AFM (Nanoscale Hybrid Microscope VN-8000 manufactured by Keyence Corporation).

### (Sample 1)

The polishing process and the subsequent cleaning were conducted under the same conditions as Working Example 1.

The cleaning (gas etching) process was conducted for 10 minutes at a hydrogen gas flow rate of 90 slm, an internal reactor pressure of 200 mbar, and a substrate temperature of 1550°C.

With respect to the SiC epitaxial growth process, SiH₄ gas was supplied 3 seconds after supply of C₃H₈ gas so as to conduct simultaneous supply to the substrate surface at SiH₄ gas and C₃H₈ gas flow rates of 48 sccm and 17.6 sccm. With respect to C/Si, 1.1 was selected. The growth process was conducted for 2 hours at an internal reactor pressure of 200 mbar, a substrate temperature of 1550°C, and a growth rate of 5 µm/h, and SiC epitaxial film of 10 µm thickness was formed.

With respect to the results of measurement by a wide-range observation type AFM and an optical surface inspection device of the SiC epitaxial wafer manufactured in this manner, Rq measured by the optical surface inspection device was 1.2 nm, Rq measured by the wide-range observation type AFM was 0.4 nm, and the maximum height difference Ry was 0.7 nm. No step bunching was observed.

### (Sample 2)

An SiC epitaxial wafer was manufactured under the same conditions as Sample 1, except for the gas etching conditions. The gas etching process differed from Sample 1 in that SiH₄ gas of 0.008 mol% concentration was added to the hydrogen gas.

The SiC epitaxial wafer manufactured in this manner was measured by an optical surface inspection device and a wide-range observation type AFM. An image identical to that of Sample 1 was observed; Rq measured by the optical surface inspection device was 1.1 nm, Rq measured by the wide-range observation type AFM was 0.4 nm, and the maximum height difference Ry was 0.7 nm.

### (Comparative Example 1 with Sample 1 and Sample 2)

An SiC epitaxial wafer was manufactured under the same conditions as Sample 1, except that, in the SiC epitaxial growth process, the SiH₄ gas and C₃H₈ gas were introduced with a C/Si concentration ratio of 1.9, and the SiH₄ gas was introduced 30 seconds after introduction of the C₃H₈ gas.

Images of the manufactured SiC epitaxial wafer measured by a wide-range observation type AFM and an optical surface inspection device are as respectively shown in Fig. 5(b) and Fig. 6(b).

In the Candela image and the AFM image, conventional step bunching was observed across the entire wafer surface. Root-mean-square roughness Rq measured by the optical surface inspection device was 1.7 nm, root-mean-square roughness Rq measured by the wide-range observation type AFM was 2.4 nm, and the maximum height difference Ry was 3.6 nm.

### (Comparative Example 2 with Sample 1 and Sample 2)

An SiC epitaxial wafer was manufactured under the same conditions as Sample 1, except that the SiH₄ gas was introduced 30 seconds after introduction of the C₃H₈ gas in the SiC epitaxial growth process. Accordingly, by way of comparison with Comparative Example 1 of Sample 1 and Sample 2, the point of difference is that the SiH₄ gas and the C₃H₈ gas were introduced with a C/Si concentration ratio of 1.1.

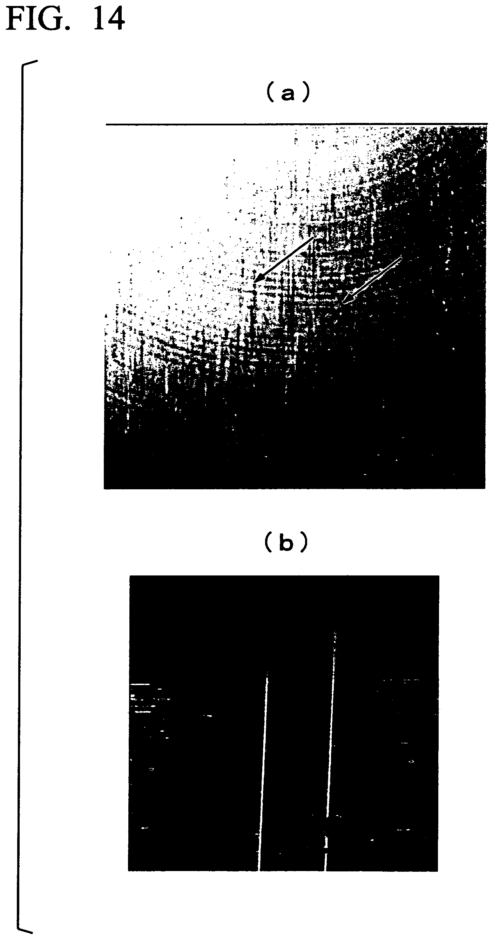

Fig. 14 (a) and (b) show a Candela image and a wide-range observation type AFM image of the manufactured SiC epitaxial wafer.

Root-mean-square roughness Rq measured by the optical surface inspection device was 1.4 nm, root-mean-square roughness Rq measured by the wide-range observation type AFM was 1.4 nm, and the maximum height difference Ry was 2.8 nm. The linear density of steps was 10 steps/mm⁻¹.

Conventional step bunching was not observed in either the Candela image or the AFM image. This result shows that the C/Si concentration ratio of the SiH₄ gas and the C₃H₈ gas is important for inhibiting the occurrence of conventional step bunching, and confirms that occurrence of conventional step bunching can be inhibited by setting the C/Si concentration ratio within a range of 0.7-1.2.

### INDUSTRIAL APPLICABILITY

The SiC epitaxial wafer produced by the method of the present invention is a step-bunching-free SiC epitaxial wafer with high uniformity of carrier concentration and film thickness which reduces triangular defects and stacking faults, and can be used to manufacture a variety of silicon carbide semiconductor devices such as power devices, high-frequency devices, and high-temperature operating devices.

## Claims

1. An SiC epitaxial wafer manufacturing method which forms an SiC epitaxial layer on a 4H-SiC single crystal substrate tilted with an off angle of 0.4°-5° in the <11-20> axis direction relative to the (0001) surface of the 4H-SiC single crystal substrate, wherein
silicon-containing gas and carbon-containing gas are supplied so that a C/Si atom number ratio of carbon and silicon in an amount required for epitaxial growth of silicon carbide is 0.7-1.2 on said substrate whose surface has been cleaned by gas etching, and silicon carbide film is epitaxially grown at a temperature of more than 1600°C and 1800°C or less, **characterized in that** the silicon-containing gas and carbon-containing gas are supplied simultaneously or with a time difference within 5 seconds,
and epitaxial growth of said silicon carbide film is conducted: (1) in the case of use of a 4H-SiC single crystal substrate with an off angle of 0.4°-2°, at a growth rate of 1-3 µm/h when a growth temperature at which silicon carbide film is epitaxially grown is >1600-1640°C, at a growth rate of 3-4 µm/h when growth temperature is 1640-1700°C, and at a growth rate of 4-10 µm/h when growth temperature is 1700-1800°C; and (2) in the case of use of a 4H-SiC single crystal substrate with an off angle of 2°-5°, at a growth rate of 2-4 µm/h when a growth temperature at which silicon carbide film is epitaxially grown is >1600-1640°C, at a growth rate of 4-10 µm/h when growth temperature is 1640-1700°C, and at a growth rate of 10-20 µm/h when growth temperature is 1700-1800°C.

2. The SiC epitaxial wafer manufacturing method according to claim 1, further comprising:
a process in which the 4H-SiC single crystal substrate is prepared whose primary surface is machined into convex form at room temperature, and that has an off angle of 0.4°-5°, before the step in which the silicon carbide film is epitaxially grown.

3. The SiC epitaxial wafer manufacturing method according to claim 2, wherein a radius of curvature of said convexity is in a range from 10 m or more to 1000 m or less.

4. The SiC epitaxial wafer manufacturing method according to any one of claims 1 to 3, comprising a process wherein polishing is conducted until a lattice disorder layer of a surface of said 4H-SiC single crystal substrate is 3nm or less, prior to cleaning of the surface by said gas etching.

5. The SiC epitaxial wafer manufacturing method according to any one of claims 1 to 3, wherein said gas etching is conducted in a hydrogen atmosphere at a temperature of 1400-1800°C.

6. The SiC epitaxial wafer manufacturing method according to claim 5, wherein said gas etching is conducted with addition of silicon-containing gas and/or carbon-containing gas to said hydrogen atmosphere.

## Patentansprüche

1. Verfahren zur Herstellung eines epitaxialen SiC-Wafers, der eine epitaxiale SiC-Schicht auf einem 4H-SiC-Einkristallsubstrat bildet, das mit einem Winkel von 0,4°-5° in der <11-20> Achsenrichtung in Bezug auf die (0001) Oberfläche des 4H-SiC-Einkristallsubstrats geneigt ist, wobei
Silicium enthaltendes Gas und Kohlenstoff enthaltendes Gas so zugeführt werden, dass das C/Si-Atomzahlverhältnis von Kohlenstoff zu Silicium in einer für das epitaxiale Wachstum von Siliciumcarbid erforderlichen Menge 0,7-1,2 auf dem Substrat ist, dessen Oberfläche durch Gasätzen gereinigt worden ist, und ein Siliciumcarbidfilm bei einer Temperatur von mehr als 1600°C und 1800°C oder weniger epitaxial gewachsen wird, **dadurch gekennzeichnet,**
**dass** das Silicium enthaltende Gas und das Kohlenstoff enthaltende Gas gleichzeitig oder mit einem Zeitunterschied von höchstens 5 Sekunden zugeführt werden,
und das epitaxiale Wachstum des Siliciumcarbidfilms durchgeführt wird: (1) wenn ein 4H-SiC-Einkristallsubstrat mit einem Neigungswinkel von 0,4°-2° eingesetzt wird, ist die Wachstumsgeschwindigkeit 1-3 µm/h, wenn die Wachstumstemperatur, bei der der Siliciumcarbidfilm epitaxial gewachsen wird, > 1600-1640°C, ist die Wachstumsgeschwindigkeit 3-4 µm/h, wenn die Wachstumstemperatur 1640-1700°C ist, und ist die Wachstumsgeschwindigkeit 4-10 µm/h, wenn die Wachstumstemperatur 1700-1800°C ist; und (2) wenn ein 4H-SiC-Einkristallsubstrat mit einem Neigungswinkel von 2-5° eingesetzt wird, ist die Wachstumsgeschwindigkeit 2-4 µm/h, wenn die Wachstumstemperatur, bei der der Siliciumcarbidfilm epitaxial gewachsen wird, > 1600-1640°C, ist die Wachstumsgeschwindigkeit 4-10 µm/h, wenn die Wachstumstemperatur 1640-1700°C ist, und ist die Wachstumsgeschwindigkeit 10-20 µm/h, wenn die Wachstumstemperatur 1700-1800°C ist.

2. Verfahren zur Herstellung eines epitaxialen SiC-Wafers nach Anspruch 1, welches außerdem umfasst:
vor der Stufe, in der der Siliciumcarbidfilm epitaxial gewachsen wird, ein Verfahren, bei dem das 4H-SiC-Einkristallsubstrat hergestellt wird, dessen primäre Oberfläche bei Raumtemperatur in eine konvexe Form überführt wird, und welches einen Neigungswinkel von 0,4°-5° aufweist.

3. Verfahren zur Herstellung eines epitaxialen SiC-Wafers nach Anspruch 2, wobei ein Radius der Krümmung der Konvexform in einem Bereich von 10 m oder mehr bis 1000 m oder weniger ist.

4. Verfahren zur Herstellung eines epitaxialen SiC-Wafers nach einem der Ansprüche 1 bis 3, welches vor dem Reinigen der Oberfläche durch das Gasätzen ein Verfahren umfasst, bei dem ein Polieren durchgeführt wird, bis die Gitterunordnungsschicht einer Oberfläche des 4H-SiC-Einkristallsubstrats 3 nm oder weniger ist.

5. Verfahren zur Herstellung eines epitaxialen SiC-Wafers nach einem der Ansprüche 1 bis 3, wobei das Gasätzen in einer Wasserstoffatmosphäre bei einer Temperatur von 1400 bis 1800°C durchgeführt wird.

6. Verfahren zur Herstellung eines epitaxialen SiC-Wafers nach Anspruch 5, wobei das Gasätzen unter Zugabe eines Silicium enthaltenden Gases und/oder eines Kohlenstoff enthaltendes Gases zu der Wasserstoffatmosphäre durchgeführt wird.

## Revendications

1. Procédé de fabrication de galette épitaxiale de SiC qui forme une couche épitaxiale de SiC sur un substrat monocristallin de 4H-SiC incliné avec un angle de déport de 0,4°-5° dans la direction axiale <11-20> par rapport à la surface (0001) du substrat monocristallin de 4H-SiC,
dans lequel un gaz contenant du silicium et un gaz contenant du carbone sont fournis de telle sorte qu'un rapport de nombre atomique C/Si entre le carbone et le silicium en une quantité requise pour une croissance épitaxiale de carbure de silicium soit de 0,7-1,2 sur ledit substrat dont la surface a été nettoyée par décapage au gaz, et un film de carbure de silicium est développé de façon épitaxiale à une température de plus de 1600 °C et de 1800°C ou moins,
**caractérisé en ce que** ledit gaz contenant du silicium et ledit gaz contenant du carbone sont fournis simultanément ou avec une différence de temps de maximum 5 secondes,
et une croissance épitaxiale dudit film de carbure de silicium est effectuée: (1) dans le cas de l'utilisation d'un substrat monocristallin de 4H-SiC présentant un angle de déport de 0,4° à 2°, à une vitesse de croissance de 1-3 µm/h lorsqu'une température de croissance à laquelle un film de carbure de silicium est développé de façon épitaxiale est >1600°C-1640°C, à une vitesse de croissance de 3-4 µm/h lorsque la température de croissance est de 1640°C-1700°C, et à une vitesse de croissance de 4-10 µm/h lorsque la température de croissance est de 1700°C-1800°C; et (2) dans le cas de l'utilisation d'un substrat monocristallin de 4H-SiC présentant un angle de déport de 2° à 5°, à une vitesse de croissance de 2-4 µm/h lorsqu'une température de croissance à laquelle un film de carbure de silicium est développé de façon épitaxiale est >1600°C-1640°C, à une vitesse de croissance de 4-10 µm/h lorsque la température de croissance est de 1640°C-1700°C, et à une vitesse de croissance de 10-20 µm/h lorsque la température de croissance est de 1700°C-1800°C.

2. Procédé de fabrication de galette épitaxiale de SiC selon la revendication 1, comprenant un outre un procédé dans lequel le substrat monocristallin de 4H-SiC est préparé, la surface primaire de celui-ci est usinée dans une forme convexe à la température ambiante, et présente un angle de déport de 0,4° à 5°, avant l'étape au cours de laquelle le film de carbure de silicium est développé de façon épitaxiale.

3. Procédé de fabrication de galette épitaxiale de SiC selon la revendication 2, dans lequel un rayon de courbure de ladite convexité est compris dans une gamme de 10 m ou plus à 1000 m ou moins.

4. Procédé de fabrication de galette épitaxiale de SiC selon l'une quelconque des revendications 1 à 3, comprenant un procédé dans lequel un polissage est effectué jusqu'à ce qu'une couche de désordre de réseau d'une surface dudit substrat monocristallin de 4H-SiC soit de 3 nm ou moins, avant le nettoyage de la surface par ledit décapage au gaz.

5. Procédé de fabrication de galette épitaxiale de SiC selon l'une quelconque des revendications 1 à 3, dans lequel ledit décapage au gaz est effectué dans une atmosphère d'hydrogène à une température de 1400°C à 1800°C.

6. Procédé de fabrication de galette épitaxiale de SiC selon la revendication 5, dans lequel ledit décapage au gaz est effectué avec un ajout de gaz contenant du silicium et/ou de gaz contenant du carbone à ladite atmosphère d'hydrogène.
